# EUROPEAN PATENT SPECIFICATION

(11) **EP 2 317 385 B1**
(45) Date of publication and mention of the grant of the patent: **08.06.2016**
(21) Application number: 10425388.5
(22) Date of filing: 20.12.2010
(51) Int. Cl.: B41C 1/05, G03F 1/00

(54) **Method for providing flexographic plates, particularly for flexographic printing system, and photoexposure device**
Verfahren zur Bereitstellung von Flexodruckplatten, insbesondere für ein Flexodrucksystem, und Fotobelichtungsvorrichtung
Procédé de préparation de plaques flexographiques, en particulier pour un système d'impression flexographique et dispositif de photoexposition

(30) Priority: 12.11.2010 IT MI20102096
(43) Date of publication of application: 04.05.2011
(73) Proprietor: Carminati, Carlo, 24121 Bergamo (IT)
(72) Inventor: Carminati, Carlo, 24121 Bergamo (IT)
(74) Representative: Modiano, Micaela Nadia

(56) References cited:
- WO-A1-2011/041046
- US-A1- 2003 112 312
- US-A1- 2005 170 287
- US-B1- 6 266 134

## Description

The present invention relates to a method for providing flexographic plates, particularly for flexographic printing systems, and to a photoexposure device used to perform such method.

Flexography is a printing system that uses flexible photopolymer plates that bear in relief the graphic element to be reproduced.

Such printing plates are wrapped around a cylinder which, by rotating sequentially first on an inking roller and then on a print medium, transfers onto the latter the ink only as regards the graphic element in relief that is present on the plate.

In flexography it is possible to print both flexible materials in reel form, such as paper or polyester, and rigid materials in sheets, such as corrugated cardboard, since flexographic plates adapt to both technologies (from a sheet or from a reel) by means of several different photopolymer compositions.

In order to achieve high-quality printing, the print points provided on the plate in relation to the graphic element to be printed must, in theory, have clearly defined contours so as to provide a sharp printed image.

The method for providing flexographic plates, particularly for flexographic printing systems, and the apparatus used to perform it therefore are considerably important.

Currently, methods for providing flexographic plates substantially consist in performing a polymerization of a plate that has a constant thickness, so as to cure the plate as a consequence of the polymerization process, and is localized so as to correspond to the graphic element to be reproduced, and in then removing the non-polymerized portion, which bears said graphic element in high relief.

More precisely, known types of method use photopolymer plates coated with a layer of black graphite, on which a step of ablation by means of a laser, according to the graphic element to be provided, is performed.

In this manner, at said graphic element the graphite is removed, leaving the photopolymer exposed.

The plates are then exposed to a light source, preferably neon tubes that emit ultraviolet rays with diffuse light.

As a consequence of this exposure, the plates are cured where the graphite has been removed because, since the graphite is no longer present, the ultraviolet rays can strike the plates, initiating polymerization. In the portions where the graphite has remained, the ultraviolet rays instead cannot reach the plates, which thus remain in the virgin state.

Once the exposure step has ended, the plates are subjected to a washing step in which, by means of brushes immersed in an adapted solvent, the non-polymerized photopolymer is removed, leaving intact the portion that, having polymerized during the exposure step, is not affected by the aggression of the solvent.

One thus moves on to the drying step, which is designed to dry the plates from the solvent.

Having reached this point, the plates thus bear in relief the desired graphic element and are subjected to a finishing step, by means of neon tubes that reproduce ultraviolet rays so as to close the polymerization process of the plate and make it ready to be mounted on the printing roller.

Such conventional methods are not devoid of drawbacks, which include the fact that the individual created print point has contours that have a rounded shape.

This drawback is linked essentially to the fact that the exposure to ultraviolet rays by means of diffuse light is such as to also affect the lateral shoulders of the individual print point, leading to print points with rounded contours which inevitably lead to a reduction in final print quality.

Examples of methods for making printing elements suitable for flexographic printing are available from the documents US 2005/0170287 A1, US 2003/0112312 A1 and US 6 266 134 B1.

The aim of the present invention is to provide a method for providing flexographic plates, particularly for flexographic printing systems, that allows to obtain a flexographic plate with print points that have clearly outlined contours.

Within this aim, an object of the present invention is to devise a method that allows to process a digital photopolymer plate by exposure to ultraviolet light, solving and overcoming, respectively, the drawbacks and limitations of the background art.

Another object of the present invention is to provide a method that requires an apparatus that has low production and management costs and has limited machine downtimes due to maintenance operations.

This aim and these and other objects that will become better apparent hereinafter are achieved by a method for providing flexographic plates, particularly for flexographic printing systems, comprising the steps set forth in claim 1, or with the photoexposure device of claim 11.

Further characteristics and advantages will become better apparent from the description of a preferred but not exclusive embodiment of a method for providing flexographic plates, particularly for flexographic printing systems, illustrated by way of non-limiting example in the accompanying drawings, wherein:
Figure 1 is a schematic view of a digital photopolymer plate during the ablation step of the method, according to the present invention;
Figure 2 is a schematic view of a digital photopolymer plate during the coating step of the method, according to the present invention;
Figure 3 is a schematic view of a digital photopolymer plate during a variation of the coating step of the method, according to the present invention;
Figure 4 is a schematic view of a digital photopolymer plate during the exposure step of the method, according to the present invention;
Figure 5 is a schematic view of a digital photopolymer plate during the washing step of the method, according to the present invention;
Figure 6 is a schematic view of a digital photopolymer plate during the drying step of the method, according to the present invention;
Figure 7 is a schematic view of a digital photopolymer plate during the finishing step of the method, according to the present invention;
Figure 8 is a further schematic view of a digital photopolymer plate obtained according to the invention with long exposure times;
Figure 9 is a perspective view of a photoexposure device used to perform the exposure step of the method, according to the present invention.

With reference to the figures, the method for providing flexographic plates, particularly for flexographic printing systems, comprises the steps described hereafter.

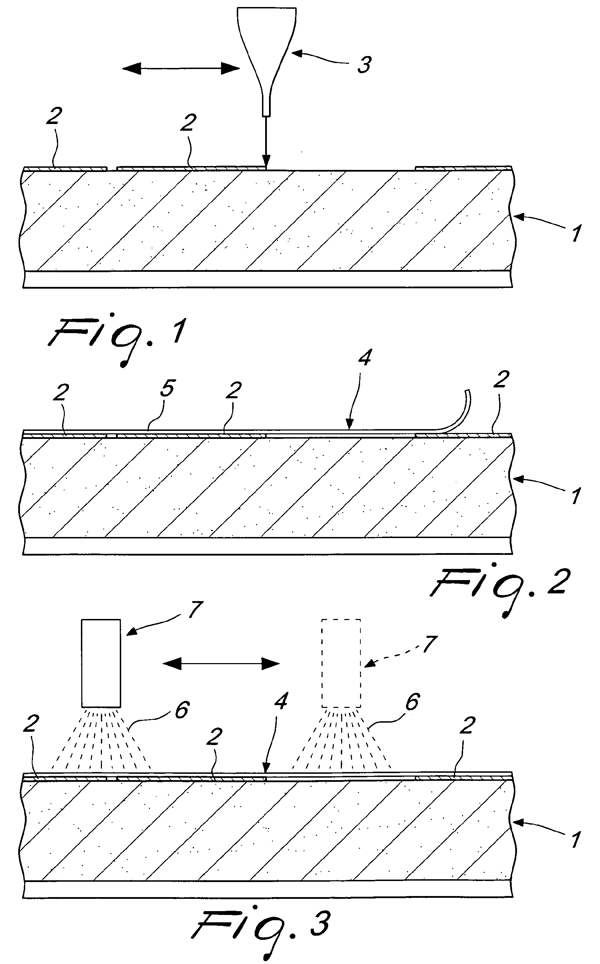

Starting from a digital photopolymer plate, generally designated by the reference numeral 1, a first surface coating thereof is performed with a layer of protective material 2, as shown in Figure 1, which is impermeable to ultraviolet rays and preferably consists of a layer of black graphite.

The digital photopolymer plate 1 is then placed in an adapted machine provided with a laser device, shown schematically in Figure 1 and designated by the reference numeral 3, which ablates the digital photopolymer plate 1 according to a preset graphic element supplied to the machine beforehand by means of an image file.

With this operation, the layer of protective material 2 is removed from the digital photopolymer plate 1 in a manner that corresponds to the print points defined by the graphic element cited above.

Advantageously, in order to prevent oxygen from making contact with the digital photopolymer plate 1 during the polymerization process, which will be described in greater detail hereinafter, a surface coating of the digital photopolymer plate 1 is performed by means of a film 4 of a material that is permeable to ultraviolet light and impermeable to oxygen, arranged so as to adhere to the ablated digital photopolymer plate 1, so as to isolate it and optimize the polymerization process, which will be described in greater detail hereinafter.

As shown in Figure 2, the film 4 can be provided by means of a film 5 made of plastic material arranged so as to adhere to the previously ablated digital photopolymer plate 1.

This coating by means of the film 5 of plastic material is performed in a lamination step by means of an adapted lamination device, not shown.

As an alternative, as shown in Figure 3, the film 4 can be provided by spraying the digital photopolymer plate 1 with a paint 6 that is permeable to ultraviolet light and impermeable to oxygen.

This spraying is performed in a painting step by means of an adapted sprayer, generally designated by the reference numeral 7.

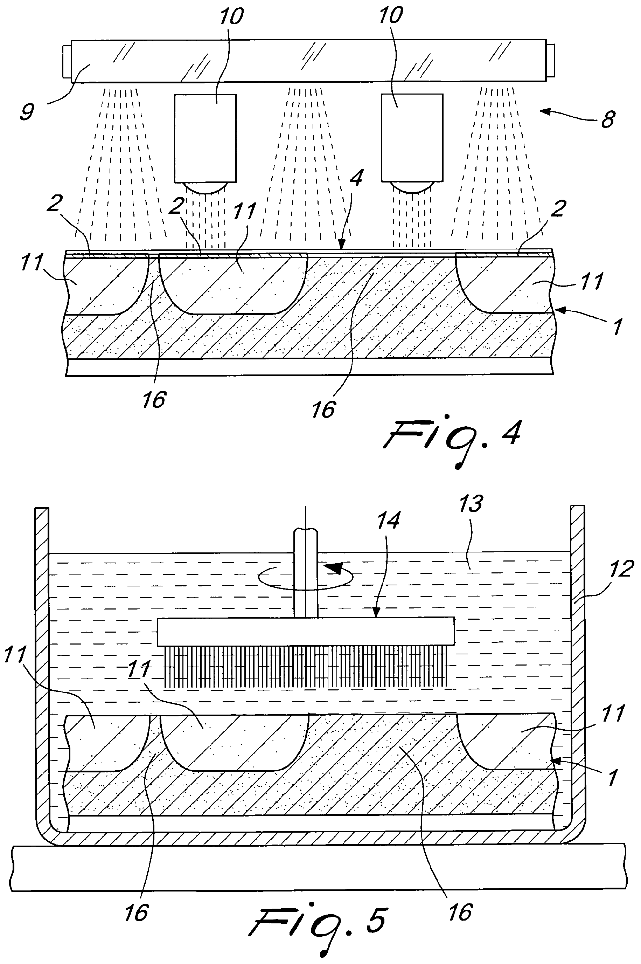

Then the process for the polymerization of the digital photopolymer plate 1 is started by means of a step of exposure to ultraviolet rays, shown schematically in Figure 4.

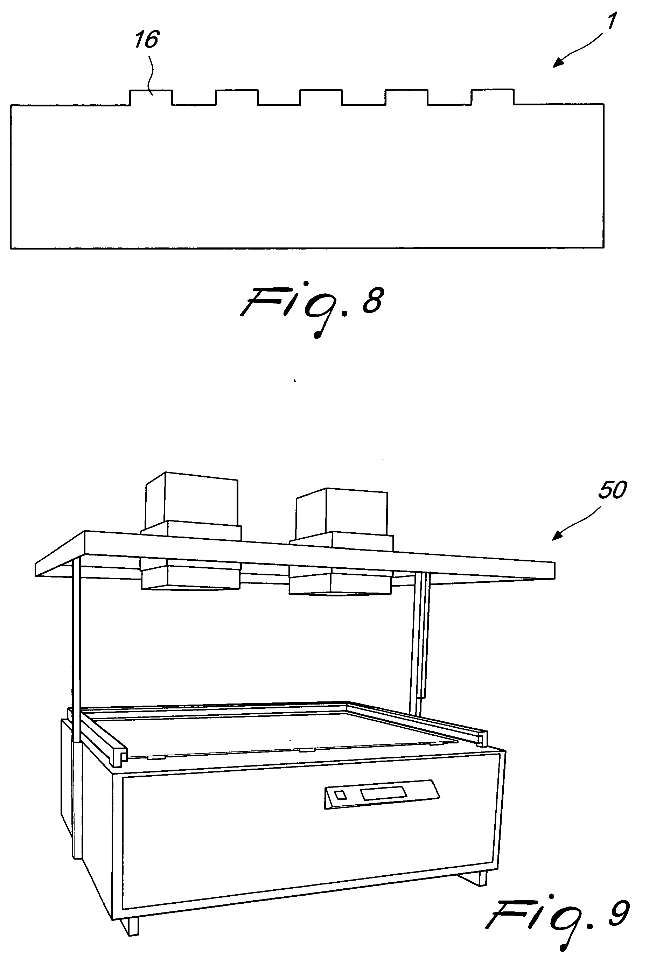

With reference to Figure 4, according to the invention, such exposure step occurs by using one or more light sources 8 adapted to generate ultraviolet light of the direct type by means of an adapted photoexposure device, illustrated by way of example in Figure 9 and generally designated by the reference numeral 50.

In order to achieve optimum irradiation, as will be described further hereinafter, sources 8 of ultraviolet light of the diffuse type are arranged alongside the sources 8 of ultraviolet light of the direct type.

More particularly, in the photoexposure device 50 first neon tubes 9 are used as light source 8 in order to generate diffuse ultraviolet light and metal halogen lamps 10, with a light spectrum preferably comprised between 360 and 365 nanometers, are used to generate direct ultraviolet light, i.e., light that reaches the digital photopolymer plate 1 perpendicularly.

Advantageously, the photoexposure device 50 is provided with high-definition reflective parabolas, which allow to obtain, with reduced exposure times, a perfect duplication of the screen and with a diffusion sheet in the upper portion of the digital photopolymer plate 1, which is moved automatically.

Once the polymerization of the digital photopolymer plate 1 has been performed, with reference to Figure 5, a washing step is performed after removing the layer 2 of protective material and the film 4 from the digital photopolymer plate 1, in order to remove the non-ablated regions 11 of the digital photopolymer plate 1.

During this washing step, the digital photopolymer plate 1 is immersed in a tank 12 filled with an adapted solvent 13 capable of chemically etching the non-ablated regions 11 of the digital photopolymer plate 1.

In the tank 12, the digital photopolymer plate 1 is brushed with brushes 14 which also are immersed in the solvent 13, so as to be able to remove the non-ablated regions 11 of the digital photopolymer plate 1.

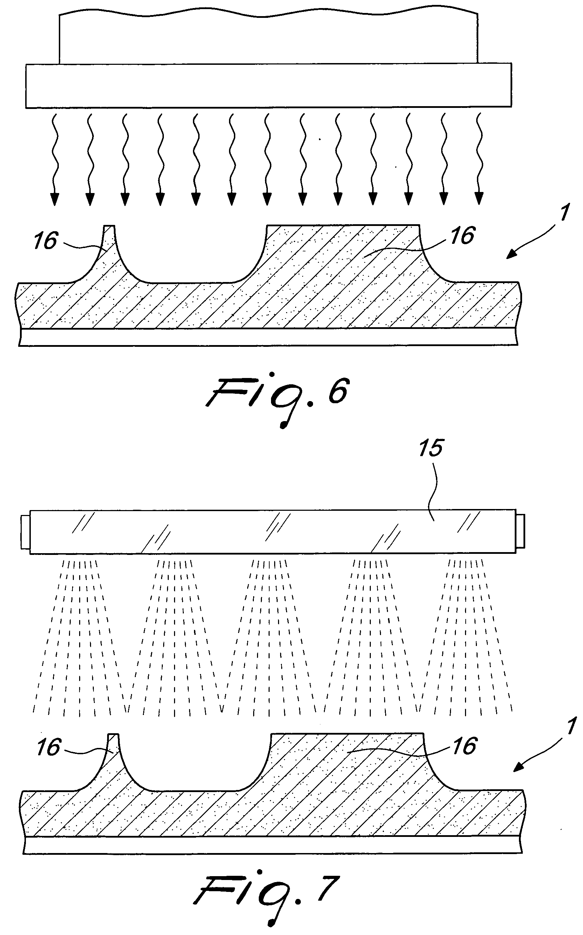

Then, with reference to Figure 6, a drying step is performed in which the digital photopolymer plate 1, once it has been made to emerge from the tank 12, is processed for the evaporation of the residual solvent 13 from the digital photopolymer plate 1.

Finally, with reference to Figure 7, the process of polymerizing the digital photopolymer plate 1 is completed by a finishing step, in which the digital photopolymer plate 1 is exposed to ultraviolet rays by means of second neon tubes 15.

In this manner, a digital photopolymer plate 1 is obtained with a series of print points 16 having a flat head, thanks to the isolation from oxygen of said digital photopolymer plate 1 during the polymerization step, which have sharp contours, i.e., with non-rounded shoulders, thanks to the exposure by means of ultraviolet light of the direct type, and are perfectly polymerized.

In particular, by performing an exposure to UV rays without oxygen and with direct light and by greatly increasing the exposure times of the background it is possible to produce a printing plate such as the one shown in Figure 8.

Advantageously, it is possible to obtain a polymerization which almost reaches the top of the plate (there is a relief of approximately 1/10 mm), so that during the printing phase the plate is even more precise, because the points can no longer move and further limit the defects linked to the less than perfect flatness of the cardboard.

In practice it has been found that the method for providing flexographic plates, particularly for flexographic printing systems, allows to obtain flexographic plates that have print points with a flat head which are perfectly polymerized and with non-rounded shoulders, in a manner that ensures better print quality thanks to excellent ink transport and to the capacity of the print point to remain particularly stable even if it is subjected to a higher printing pressure.

In particular, this allows, during the printing of flexible packaging, to apply more pressure without causing the dots of four-color printing to dirty the print and at the same time allows to print perfectly the solid backgrounds that are present on said plate. With the possibility, therefore, to assemble screens, i.e., the sets of print points, and lines, i.e., solid backgrounds, the economic advantage thereof is evident. The need to provide a larger number of flexographic plates to separate the lines from the screens is in fact eliminated.

Another advantage of the method according to the present invention consists in that, during the printing of rigid sheets, the printing defects caused by the typical undulations of corrugated cardboard are limited. This is due to the fact that the flat print point, by remaining more stable thanks to its shape, adapts better to said imperfections of the cardboard. Printing is thus very uniform and without defects caused by excessive pressure.

Another advantage of the method according to the present invention consists in that it provides low manufacturing and management costs and also reduces machine downtimes if compared with known types of method.

The method for providing flexographic plates, particularly for flexographic printing systems, thus conceived is susceptible of numerous modifications and variations, all of which are within the scope of the appended claims.

All the details may further be replaced with other technically equivalent elements.

In practice, the materials used, so long as they are compatible with the specific use, as well as the contingent shapes and dimensions, may be any according to requirements.

The disclosures in Italian Patent Application no. MI2010A002096, are those from which this application claims priority.

Where technical features mentioned in any claim are followed by reference signs, those reference signs have been included for the sole purpose of increasing the intelligibility of the claims and accordingly such reference signs do not have any limiting effect on the interpretation of each element identified by way of example by such reference signs.

## Claims

1. A method for providing flexographic plates, particularly for flexographic printing systems, comprising the following steps:
- first surface coating of a digital photopolymer plate (1) with a layer of protective material (2) that is impermeable to ultraviolet rays,
- ablating by means of a laser device (3) according to a preset graphic element said digital photopolymer plate (1) in order to remove said layer of protective material (2) in a manner that corresponds to the print points that define said graphic element,
- exposing, by means light sources (8), said digital photopolymer plate (1) for its polymerization in a manner that corresponds to the previously ablated regions (16),
- washing said polymerized digital photopolymer plate (1) for removal of the non-ablated regions (11) of said digital photopolymer plate (1),
- finishing said digital photopolymer plate (1) by means of an exposure to ultraviolet rays to complete the polymerization of said digital photopolymer plate (1),
**characterized in that** said exposure step comprises exposing said digital photopolymer plate (1) to said or more light sources (8) by means of a photoexposure device (50) comprising sources (10) adapted to generate ultraviolet light of the direct type, i.e. light that reaches the digital photopolymer plate (1) perpendicularly, alongside sources (9) of ultraviolet light of the diffuse type.

2. The method according to the preceding claim, **characterized in that** said light sources (8) comprise metal halogen lamps (10) with a light spectrum preferably comprised between 360 and 365 nanometers to generate direct ultraviolet light.

3. The method according to one or more of the preceding claims, **characterized in that** during said exposure step said light sources (8) adapted to generate ultraviolet light both of the direct type and of the diffuse type, comprise first neon tubes (9) for generating diffuse ultraviolet light.

4. The method according to one or more of the preceding claims, **characterized in that** said layer of protective material (2) is provided by a layer of black graphite.

5. The method according to one or more of the preceding claims, **characterized in that** said washing step is performed by brushing said polymerized digital photopolymer plate (1) with brushes (14) immersed in a solvent (13) to remove the non-ablated regions (11) of said digital photopolymer plate (1).

6. The method according to one or more of the preceding claims, **characterized in that** it comprises a step of drying said digital photopolymer plate (1) processed in said washing step for the evaporation of said residual solvent (13) from said digital photopolymer plate (1), said drying step being performed between said washing step and said finishing step.

7. The method according to one or more of the preceding claims, **characterized in that** in said finishing step said digital photopolymer plate (1) is exposed to ultraviolet rays by means of second neon tubes (15).

8. The method according to one or more of the preceding claims, **characterized in that** it comprises a second surface coating of said digital photopolymer plate (1) by means of a film (4) made of a material that is permeable to ultraviolet light and impermeable to oxygen, placed so as to adhere to said digital photopolymer plate (1) to isolate it from oxygen and to optimize the polymerization process, said coating step being performed between said ablation step and said exposure step.

9. The method according to claim 8, **characterized in that** said film (4) is provided by means of a film of plastic material (5) which is arranged so as to adhere to said digital photopolymer plate (1) by means of a lamination step performed with a lamination device.

10. The method according to claim 8, **characterized in that** said film (4) is provided by spraying said digital photopolymer plate (1) with a paint (6) that is permeable to ultraviolet light and impermeable to oxygen, by means of a step of painting with a spraying device (7).

11. A photoexposure device (50) for the polymerization of digital photopolymer plates and the like to obtain flexographic plates, particularly for flexographic printing systems, the digital photopolymer plates (1) being provided with a method according to one or more of the preceding claims, **characterized in that** it comprises light sources (8, 9), which are adapted to generate diffuse ultraviolet light alongside sources (8, 10) adapted to generate direct ultraviolet light, i.e. light that reaches the digital photopolymer plate (1) perpendicularly, in the direction of said digital photopolymer plate (1) to be polymerized.

12. The photoexposure device (50) according to claim 11, **characterized in that** said light sources (8) comprise at least one neon tube (9) that is adapted to generate said diffuse ultraviolet light.

13. The photoexposure device (50) according to one or more of claims 11 and 12, **characterized in that** said light sources (8) comprise at least one metal halogen lamp (10) with a light spectrum preferably comprised between 360 and 365 nanometers.

14. The photoexposure device (50) according to one or more of claims 11 to 13, **characterized in that** it comprises a plurality of reflective parabolas arranged above said digital photopolymer plate to be polymerized in order to reduce exposure times.

## Patentansprüche

1. Ein Verfahren zur Bereitstellung von flexografischen Druckplatten, insbesondere für Flexografische Drucksysteme, das folgende Schritte umfasst:
- erste Oberflächenbeschichtung einer digitalen Photopolymerplatte (1) mit einer Schicht von Schutzmaterial (2), das undurchlässig für ultraviolette Strahlen ist,
- Abtragen mit Hilfe einer Laservorrichtung (3) der digitalen Photopolymerplatte (1) entsprechend einem vordefinierten grafischen Element, um die Schicht von Schutzmaterial (2) auf eine Art zu entfernen, die den Druckpunkten entspricht, welche das grafische Element bestimmen,
- Aussetzen der digitalen Photopolymerplatte (1) mit Hilfe von Lichtquellen (8) zum Zwecke ihrer Polymerisation auf eine Art, die den zuvor abgetragenen Bereichen (16) entspricht,
- Waschen der polymerisierten digitalen Photopolymerplatte (1) zum Entfernen der nicht abgetragenen Bereiche (11) der digitalen Photopolymerplatte (1),
- Endbearbeiten der digitalen Photopolymerplatte (1) durch Aussetzen gegenüber ultravioletten Strahlen, um die Polymerisation der digitalen Photopolymerplatte (1) abzuschießen,
**dadurch gekennzeichnet, dass** der Schritt des Aussetzens Folgendes umfasst:
Aussetzen der digitalen Photopolymerplatte (1) gegenüber den oder noch mehr Lichtquellen (8) mit Hilfe einer Bildbelichtungsvorrichtung (50), die Quellen (10) umfasst,
welche geeignet sind, ultraviolettes Licht der direkten Art zu erzeugen, d. h. Licht, das die digitale Photopolymerplatte (1) senkrecht erreicht, gemeinsam mit Quellen (9) für ultraviolettes Licht der diffusen Art.

2. Das Verfahren gemäß dem obigen Anspruch, **dadurch gekennzeichnet, dass** die Lichtquellen (8) Metall-Halogen-Lampen (10) mit einem Lichtspektrum vorzugsweise zwischen 360 und 365 Nanometern umfassen, um direktes ultraviolettes Licht zu erzeugen.

3. Das Verfahren gemäß einem oder mehreren der obigen Ansprüche, **dadurch gekennzeichnet, dass** während des Schritt des Aussetzens die Lichtquellen (8), die geeignet sind, ultraviolettes Licht zu erzeugen, sowohl vom direkten Typ als auch vom diffusen Typ, erste Neonröhren (9) zum Erzeugen von diffusem ultravioletten Licht umfassen.

4. Das Verfahren gemäß einem oder mehreren der obigen Ansprüche, **dadurch gekennzeichnet, dass** die Schicht aus Schutzmaterial (2) durch eine Schicht aus schwarzem Graphit bereitgestellt wird.

5. Das Verfahren gemäß einem oder mehreren der obigen Ansprüche, **dadurch gekennzeichnet, dass** der Schritt des Waschens durchgeführt wird durch Bürsten der polymerisierten digitalen Photopolymerplatte (1) mit Bürsten (14), die in ein Lösungsmittel (13) eingetaucht wurden, zum Entfernen der nicht abgetragenen Bereiche (11) der digitalen Photopolymerplatte (1).

6. Das Verfahren gemäß einem oder mehreren der obigen Ansprüche, **dadurch gekennzeichnet, dass** es einen Schritt des Trocknens der digitalen Photopolymerplatte (1) umfasst, die in dem Waschschritt bearbeitet wurde, zur Verdampfung des restlichen Lösungsmittels (13) von der digitalen Photopolymerplatte (1), wobei der Trocknungsschritt zwischen dem Waschschritt und dem Endbearbeitungsschritt durchgeführt wird.

7. Das Verfahren gemäß einem oder mehreren der obigen Ansprüche, **dadurch gekennzeichnet, dass** in dem Endbearbeitungsschritt die digitale Photopolymerplatte (1) mit Hilfe zweiter Neonröhren (15) ultravioletten Strahlen ausgesetzt ist.

8. Das Verfahren gemäß einem oder mehreren der obigen Ansprüche, **dadurch gekennzeichnet, dass** es eine zweite Oberflächenbeschichtung der digitalen Photopolymerplatte (1) mit einem Film (4) umfasst, der aus einem Material besteht, das durchlässig für ultraviolettes Licht und undurchlässig für Sauerstoff ist, positioniert, um an der digitalen Photopolymerplatte (1) zu haften, um sie gegenüber Sauerstoff zu isolieren und den Polymerisationsprozess zu optimieren, wobei der Beschichtungsschritt zwischen dem Schritt des Abtragens und des Aussetzens durchgeführt wird.

9. Das Verfahren gemäß Anspruch 8, **dadurch gekennzeichnet, dass** der Film (4) durch einen Film aus Kunststoffmaterial (5) bereitgestellt wird, der mit Hilfe eines Laminierungsschritts, der mit einer Laminiervorrichtung durchgeführt wird, angeordnet wird, um an der digitalen Photopolymerplatte (1) zu haften.

10. Das Verfahren gemäß Anspruch 8, **dadurch gekennzeichnet, dass** der Film (4) bereitgestellt wird durch Besprühen der digitalen Photopolymerplatte (1) mit einer Farbe (6), die durchlässig für ultraviolettes Licht und undurchlässig für Sauerstoff ist, durch einen Schritt des Malens mit einer Sprühvorrichtung (7).

11. Eine Bildbelichtungsvorrichtung (50) für die Polymerisation digitaler Photopolymerplatten und dergleichen, um flexografische Druckplatten, insbesondere für flexografische Drucksysteme, zu erhalten, wobei die digitalen Photopolymerplatten (1) mit Hilfe eines Verfahrens gemäß einem oder mehreren der vorstehenden Ansprüche bereitgestellt werden, **dadurch gekennzeichnet, dass** sie Lichtquellen (8, 9) umfasst, die ausgebildet sind, um diffuses ultraviolettes Licht zu erzeugen, gemeinsam mit Quellen (8, 10), die ausgebildet sind, um direktes ultraviolettes Licht, d. h. Licht zu erzeugen, das die digitale Photopolymerplatte (1) senkrecht erreicht, in Richtung der zu polymerisierenden digitalen Photopolymerplatte (1).

12. Die Bildbelichtungsvorrichtung (50) gemäß Anspruch 11, **dadurch gekennzeichnet, dass** die Lichtquellen (8) mindestens eine Neonröhre (9) umfassen, die ausgebildet ist, um das diffuse ultraviolette Licht zu erzeugen.

13. Die Bildbelichtungsvorrichtung (50) gemäß einem oder mehreren der Ansprüche 11 und 12, **dadurch gekennzeichnet, dass** die Lichtquellen (8) mindestens eine Metall-Halogen-Lampe (10) mit einem Lichtspektrum umfassen, das vorzugsweise zwischen 360 und 365 Nanometern liegt.

14. Die Bildbelichtungsvorrichtung (50) gemäß einem oder mehreren der Ansprüche 11 bis 13, **dadurch gekennzeichnet, dass** sie eine Vielzahl von Parabolspiegeln umfasst, die oberhalb der zu polymerisierenden digitalen Photopolymerplatte angeordnet sind, um Belichtungszeiten zu reduzieren.

## Revendications

1. Procédé de préparation de plaques flexographiques, en particulier pour systèmes d'impression flexographiques, comprenant les étapes suivantes :
- premier revêtement de surface d'une plaque photopolymère numérique (1) avec une couche de matériau de protection (2) qui est imperméable aux rayons ultraviolets,
- ablation au moyen d'un dispositif laser (3) selon un élément graphique prédéfini de ladite plaque photopolymère numérique (1) afin de retirer ladite couche de matériau de protection (2) d'une manière qui correspond aux points d'impression qui définissent ledit élément graphique,
- exposition, au moyen de sources de lumière (8), de ladite plaque photopolymère numérique (1) pour sa polymérisation d'une manière qui correspond aux régions précédemment ablatées (16),
- lavage de ladite plaque photopolymère numérique polymérisée (1) pour le retrait des régions non ablatées (11) de ladite plaque photopolymère numérique (1),
- finition de ladite plaque photopolymère numérique (1) au moyen d'une exposition aux rayons ultraviolets pour achever la polymérisation de ladite plaque photopolymère numérique (1),
**caractérisé en ce que** ladite étape d'exposition comprend l'exposition de ladite plaque photopolymère numérique (1) à ladite ou auxdites sources de lumière (8) au moyen d'un dispositif de photoexposition (50) comprenant des sources (10) adaptées à générer une lumière ultraviolette du type direct, c'est-à-dire une lumière qui atteint la plaque photopolymère numérique (1) perpendiculairement, parallèlement à des sources (9) de lumière ultraviolette du type diffus.

2. Procédé selon la revendication précédente, **caractérisé en ce que** lesdites sources de lumière (8) comprennent des lampes halogènes métalliques (10) avec un spectre lumineux compris de préférence entre 360 et 365 nanomètres pour générer une lumière ultraviolette directe.

3. Procédé selon une ou plusieurs des revendications précédentes, **caractérisé en ce qu'**au cours de ladite étape d'exposition lesdites sources de lumière (8) adaptées à générer une lumière ultraviolette à la fois du type direct et du type diffus, comprennent des premiers tubes à néon (9) pour générer une lumière ultraviolette diffuse.

4. Procédé selon une ou plusieurs des revendications précédentes, **caractérisé en ce que** ladite couche de matériau de protection (2) est préparée au moyen d'une couche de graphite noir.

5. Procédé selon une ou plusieurs des revendications précédentes, **caractérisé en ce que** ladite étape de lavage est réalisée par brossage de ladite plaque photopolymère numérique polymérisée (1) avec des brosses (14) immergées dans un solvant (13) pour retirer les régions non ablatées (11) de ladite plaque photopolymère numérique (1).

6. Procédé selon une ou plusieurs des revendications précédentes, **caractérisé en ce qu'**il comprend une étape de séchage de ladite plaque photopolymère numérique (1) traitée dans ladite étape de lavage pour évaporation dudit solvant résiduel (13) de ladite plaque photopolymère numérique (1), ladite étape de séchage étant exécutée entre ladite étape de lavage et ladite étape de finition.

7. Procédé selon une ou plusieurs des revendications précédentes, **caractérisé en ce que** dans ladite étape de finition ladite plaque photopolymère numérique (1) est exposée à des rayons ultraviolets au moyen de seconds tubes à néon (15).

8. Procédé selon une ou plusieurs des revendications précédentes, **caractérisé en ce qu'**il comprend un second revêtement de surface de ladite plaque photopolymère numérique (1) au moyen d'un film (4) composé d'un matériau qui est perméable à la lumière ultraviolette et imperméable à l'oxygène, placé de manière à adhérer à ladite plaque photopolymère numérique (1) pour l'isoler de l'oxygène et optimiser le processus de polymérisation, ladite étape de revêtement étant exécutée entre ladite étape d'ablation et ladite étape d'exposition.

9. Procédé selon la revendication 8, **caractérisé en ce que** ledit film (4) est préparé au moyen d'un film de matière plastique (5) qui est agencé de manière à adhérer à ladite plaque photopolymère numérique (1) par le biais d'une étape de stratification réalisée avec un dispositif de stratification.

10. Procédé selon la revendication 8, **caractérisé en ce que** ledit film (4) est préparé par pulvérisation de ladite plaque photopolymère numérique (1) avec une peinture (6) qui est perméable à la lumière ultraviolette et imperméable à l'oxygène, par le biais d'une étape de peinture avec un dispositif de pulvérisation (7).

11. Dispositif de photoexposition (50) pour la polymérisation de plaques photopolymères numériques et similaire afin d'obtenir des plaques flexographiques, en particulier pour systèmes d'impression flexographiques, les plaques photopolymères numériques (1) étant préparées au moyen d'un procédé selon une ou plusieurs des revendications précédentes, **caractérisé en ce qu'**il comprend des sources de lumière (8, 9), qui sont adaptées à générer une lumière ultraviolette diffuse parallèlement à des sources (8, 10) adaptées à générer une lumière ultraviolette directe, c'est-à-dire une lumière qui atteint la plaque photopolymère numérique (1) perpendiculairement, dans la direction de ladite plaque photopolymère numérique (1) devant être polymérisée.

12. Dispositif de photoexposition (50) selon la revendication 11, **caractérisé en ce que** lesdites sources de lumière (8) comprennent au moins un tube à néon (9) qui est adapté à générer ladite lumière ultraviolette diffuse.

13. Dispositif de photoexposition (50) selon une ou plusieurs des revendications 11 et 12, **caractérisé en ce que** lesdites sources de lumière (8) comprennent au moins une lampe halogène métallique (10) avec un spectre lumineux compris de préférence entre 360 et 365 nanomètres.

14. Dispositif de photoexposition (50) selon une ou plusieurs des revendications 11 à 13, **caractérisé en ce qu'**il comprend une pluralité de paraboles réfléchissantes agencées au-dessus de ladite plaque photopolymère numérique devant être polymérisée afin de réduire les temps d'exposition.
